# EUROPEAN PATENT APPLICATION

(11) **EP 4 686 325 A1**
(43) Date of publication of application: **28.01.2026**
(21) Application number: 24822328.1
(22) Date of filing: 21.03.2024
(51) Int. Cl.: H05K 7/02

(54) **ELECTRONIC DEVICE**

(30) Priority: 16.06.2023 CN 202310722386
(71) Applicant: Honor Device Co., Ltd., Shenzhen 518040 (CN)
(72) Inventor: XUE, Kangle, Shenzhen, Guangdong 518040 (CN); ZHANG, Yihe, Shenzhen, Guangdong 518040 (CN); WANG, Chenyu, Shenzhen, Guangdong 518040 (CN); YANG, Lijun, Shenzhen, Guangdong 518040 (CN)
(74) Representative: Isarpatent
(86) International application number: PCT/CN2024/082960
(87) International publication number: WO 2024/255372

(57) **Abstract**

This application discloses an electronic device, including a rotating shaft, and a first body and a second body that are respectively disposed on two sides of the rotating shaft. The first body includes a first circuit board. The first circuit board is spaced from the rotating shaft. A cable is disposed between the first circuit board and the rotating shaft, and at least partially extends in an axial direction of the rotating shaft. In this way, the cable may be cabled externally instead of being cabled on the first circuit board, to reduce occupation of a layout area on the first circuit board, so that the first circuit board has a larger layout area for arranging another functional component. In addition, the first circuit board can be further prevented from causing signal interference to the cable, thereby ensuring signal quality.

## Description

This application claims priority to Chinese Patent Application No. 2023107223866, entitled "ELECTRONIC DEVICE" and filed on June 16, 2023, which is incorporated herein by reference in its entirety.

### TECHNICAL FIELD

This application relates to the field of terminal device technologies, and in particular, to an electronic device.

### BACKGROUND

An electronic device is usually configured with a cable. The cable is configured to connect electronic components in the electronic device, for example, the cable may implement signal transmission between two electronic components.

The cable is usually cabled on a circuit board of the electronic device. However, such a cabling manner occupies a layout area of the circuit board. In this case, another functional component cannot be disposed on the circuit board and the circuit board causes interference to the cable, which affects signal quality.

### SUMMARY

This application provides an electronic device, to resolve a problem that an existing cabling manner occupies a layout area of a circuit board and affects signal quality.

This application provides an electronic device, including a rotating shaft, and a first body and a second body that are respectively disposed on two sides of the rotating shaft. The first body includes: a first circuit board, where the first circuit board is spaced from the rotating shaft; and a cable, disposed between the first circuit board and the rotating shaft, and at least partially extending in an axial direction of the rotating shaft. In this way, the cable may be cabled externally instead of being cabled on the first circuit board. Such a cabling manner does not occupy a layout area of the first circuit board, so that the first circuit board has a larger layout area for arranging another functional component. In addition, signal interference of the first circuit board to the cable may be further reduced, thereby ensuring signal quality.

In some embodiments of this application, the first body further includes: a bracket, disposed between the first circuit board and the rotating shaft; and the bracket includes a cable slot, a cabling direction of the cable slot is parallel to the rotating shaft, and the cable slot is used for cabling of the cable. In this way, a cabling route of the cable may be better restricted, to avoid bending or offset.

In some embodiments of this application, the bracket includes a main bracket, a side plate, and a support plate, the main bracket is close to the rotating shaft, the side plate is close to the first circuit board, and there is a gap between the main bracket and the side plate; and the main bracket is connected to the side plate by using the support plate to form the cable slot. In this way, the cable slot with an opening on one side may be formed, thereby facilitating laying of the cable.

In some embodiments of this application, the bracket further includes a baffle plate; the baffle plate is located at an exit end of the cable slot and is connected to the support plate, and the baffle plate is perpendicular to the cabling direction; and the baffle plate is configured to limit a position of the cable. In this way, the baffle plate may be used to prevent the cable from being cabled beyond a region in which the bracket is located, and may also be used to change the cabling direction of the cable.

In some embodiments of this application, there is a first distance L₁ between the baffle plate and the side plate, so that an exit is formed between the baffle plate and the side plate, and the exit faces the first circuit board. In this way, a direction of the cable can be changed at the exit, so that the cable is continuously cabled toward the first circuit board.

In some embodiments of this application, the bracket further includes a guide plate; the guide plate is located at a joint between the support plate and the baffle plate and forms an inclined surface facing the side plate; and the guide plate is configured to guide the cable. In this way, the guide plate may be used to support and guide the cable.

In some embodiments of this application, the main bracket includes a first sidewall facing the side plate, the first sidewall includes at least one spaced first cable clamp part, and the first cable clamp part protrudes toward the side plate; the side plate includes a second sidewall facing the first sidewall, the second sidewall includes at least one spaced second cable clamp part, and the second cable clamp part protrudes toward the first sidewall; and the first cable clamp part and the second cable clamp part are configured to fasten the cable. In this way, the cable may be fastened by using the first cable clamp parts and the second cable clamp parts, to prevent the cable from being released from the cable slot, thereby avoiding interaction between the cable and another component in the first body.

In some embodiments of this application, the main bracket includes a first chamfer, the first chamfer is located at an edge that is of the first sidewall and that is away from the support plate; and the side plate includes a second chamfer, and the second chamfer is located at an edge that is of the second sidewall and that is away from the support plate. In this way, it is convenient for laying of the cable, thereby preventing the bracket from scratching the cable.

In some embodiments of this application, the electronic device further includes a flexible printed circuit; the first body further includes a middle frame, a region that is of the middle frame and that is close to the rotating shaft includes a through hole, and the first circuit board is disposed on the middle frame and is close to the through hole; a first end of the flexible printed circuit is connected to the first circuit board, and a second end of the flexible printed circuit passes through the through hole to be connected to the second body; and the bracket is disposed in the through hole and is connected to the middle frame, and the bracket is configured to seal the through hole.

In some embodiments of this application, the middle frame includes a first part located on a side that is of the through hole and that is away from the rotating shaft and a second part located on a side that is of the through hole and that is close to the rotating shaft; the first part includes a first side surface facing the through hole, and the second part includes a second side surface facing the through hole; a sealing part is disposed on the first side surface, and the sealing part extends toward the second side surface along the first side surface; the sealing part is spaced from the second side surface to form a first channel through which the flexible printed circuit passes; and a second end of the flexible printed circuit extends along the sealing part and passes through the first channel to reach the second body. In this way, it is convenient for the flexible printed circuit to pass through the middle frame, to be connected between the first body and the second body.

In some embodiments of this application, the sealing part is adhered to the flexible printed circuit by using an adhesive layer. In this way, the flexible printed circuit may be fastened to the sealing part, and the flexible printed circuit may further seal the through hole.

In some embodiments of this application, the bracket includes a first contact surface facing the sealing part, a second contact surface facing the second side surface, and third contact surfaces located on two ends of the first contact surface in the cabling direction; the middle frame includes two third side surfaces configured to connect the first side surface to the second side surface in the cabling direction; the first contact surface abuts against a region that is of the flexible printed circuit and that is configured to be adhered to the sealing part, the second contact surface abuts against the second side surface, and the third contact surfaces abut against the third side surfaces, to seal the through hole. In this way, the contact surfaces of the bracket may abut against corresponding side surfaces of the middle frame, thereby improving a sealing effect on the through hole.

In some embodiments of this application, the bracket includes an accommodating port; the accommodating port is continuously formed on the first contact surface, the second contact surface, and the third contact surfaces; a sealing rib is filled in the accommodating port, and the sealing rib separately abuts against the flexible printed circuit and the second side surface and the third side surface of the middle frame, to seal the through hole. In this way, the bracket abuts against the middle frame by using the sealing rib, thereby further improving the sealing effect.

In some embodiments of this application, the bracket includes a first fastening part and a second fastening part; the first fastening part and the second fastening part are located on two ends of the bracket in the cabling direction; and the first fastening part and the second fastening part are configured to be connected to the middle frame. In this way, the bracket may be stably fastened to the middle frame, to ensure a sealing effect of the bracket on the through hole.

In some embodiments of this application, the electronic device further includes a second circuit board and a radio frequency chip module; the radio frequency chip module is disposed on the first circuit board and is connected to the first circuit board; and the second circuit board is disposed, in the axial direction of the rotating shaft, on a side that is of the first circuit board and that is away from the radio frequency chip module. In this way, it is convenient for laying of the cable between the second circuit board and the first circuit board, to implement signal transmission between the second circuit board and the radio frequency chip module.

**In** some embodiments of this application, the cable is a radio frequency cable; one end of the radio frequency cable is connected to the second circuit board, and the other end of the radio frequency cable passes through the cable slot and extends to a first region of the first circuit board, to be connected to the first circuit board; and the first region is a region that is of the first circuit board and that is close to the radio frequency chip module. In this way, a signal may be received through the cable connected to the second circuit board, and transmitted to the first circuit board, thereby implementing signal transmission.

**In** some embodiments of this application, the cable is a radio frequency cable; one end of the radio frequency cable is connected to a second region of the first circuit board, and the other end of the radio frequency cable passes through the cable slot and is connected to a first region of the first circuit board; and the first region is a region that is of the first circuit board and that is close to the radio frequency chip module, and the second region is a region that is of the first circuit board and that is away from the radio frequency chip module. In this way, different signals may be transmitted through different cables.

**In** some embodiments of this application, the side plate includes an opening; the opening is in communication with the cable slot; the opening faces the second region of the first circuit board; and the other end of the radio frequency cable passes through the opening and the cable slot and is connected to the first region of the first circuit board. In this way, intra-board signal transmission may be implemented.

### BRIEF DESCRIPTION OF DRAWINGS

To describe technical solutions of this application more clearly, the following briefly describes accompanying drawings required in embodiments. Apparently, a person of ordinary skill in the art may still derive other accompanying drawings from these accompanying drawings without creative efforts.
FIG. 1 is a schematic diagram of a structure of a radio frequency cable according to an embodiment of this application;
FIG. 2A is a schematic diagram of an internal structure of an electronic device;
FIG. 2B is a schematic diagram of a local part in a region A in FIG. 2A;
FIG. 3 is a schematic diagram of a structure of an electronic device 100 according to an embodiment of this application;
FIG. 4 is a schematic diagram of a first internal structure of an electronic device 100 according to an embodiment of this application;
FIG. 5 is a schematic diagram of a second internal structure of an electronic device 100 according to an embodiment of this application;
FIG. 6 is a schematic diagram of a first structure of a first body 110 according to an embodiment of this application;
FIG. 7 is a schematic diagram of a structure of a region B in FIG. 6;
FIG. 8 is a schematic diagram of a first structure of a bracket 204 according to an embodiment of this application;
FIG. 9 is a schematic diagram of a second structure of a bracket 204 according to an embodiment of this application;
FIG. 10 is a view of a local part that is seen from a cross section D-D in FIG. 8;
FIG. 11 is a schematic diagram of a structure of a region E in FIG. 9;
FIG. 12 is a side view of a bracket 204 according to an embodiment of this application;
FIG. 13A is a schematic diagram of a local part of a middle frame 201 according to an embodiment of this application;
FIG. 13B is a schematic diagram of a first local part that is seen from a cross section C-C in FIG. 7;
FIG. 14 is a schematic diagram of an assembly structure of a bracket 204 and a radio frequency cable 205 according to an embodiment of this application;
FIG. 15 is a schematic diagram of a second structure of a first body 110 according to an embodiment of this application;
FIG. 16 is a schematic diagram of a third structure of a bracket 204 according to an embodiment of this application;
FIG. 17 is a schematic diagram of a fourth structure of a bracket 204 according to an embodiment of this application;
FIG. 18 is a schematic diagram of a fifth structure of a bracket 204 according to an embodiment of this application;
FIG. 19 is a schematic diagram of a second local part that is seen from a cross section C-C in FIG. 7;
FIG. 20 is a schematic diagram of a structure of a sealing rib 20481 according to an embodiment of this application; and
FIG. 21 is a schematic diagram of an assembly structure of a bracket 204 and a sealing rib 20481 according to an embodiment of this application.

### DESCRIPTION OF EMBODIMENTS

The following clearly describes the technical solutions in the embodiments of this application with reference to the accompanying drawings in the embodiments of this application. It is clear that the described embodiments are some but not all of the embodiments of this application. Other embodiments obtained by a person of ordinary skill in the art based on the embodiments of this application without creative efforts shall fall within the protection scope of this application.

In the descriptions of this application, it should be understood that the terms such as "first" and "second" are merely used for description, but should not be understood as indicating or implying relative importance or implicitly indicating a quantity of indicated technical features. Therefore, a feature defined by "first", "second", and the like may explicitly or implicitly include one or more such features. In the descriptions of this application, unless otherwise stated, "a plurality of" means two or more.

In the descriptions of this application, it should be noted that, unless otherwise specified and limited, the terms "mount", "connection", and "connect" should be understood in a broad sense, for example, may indicate a fixed connection, a detachable connection, an integral connection, a mechanical connection, an electrical connection, mutual communication, a direct connection, an indirect connection through an intermediate medium, an internal connection between two elements, or an interaction relationship between two elements. A person of ordinary skill in the art may understand specific meanings of the foregoing terms in the present invention based on a specific situation.

The following describes technical terms in the embodiments of this application for ease of understanding by a person skilled in the art.

A radio frequency cable (RF cable, hereinafter referred to as a cable line) is a common signal cable in an electronic device. The cable line may include an inner conductor and an outer conductor that wraps the inner conductor. The inner conductor and the outer conductor are coaxial, and the inner conductor and the outer conductor form a current loop, to perform signal transmission. There is an insulation medium between the inner conductor and the outer conductor, and the insulation medium is used to ensure that a distance between the inner conductor and the outer conductor is always the same, thereby avoiding reducing a signal transmission power and further avoiding reducing signal strength. The outer conductor is wrapped by an insulation layer, and the insulation layer implements an insulation function to shield electromagnetic interference. The cable line is usually used for long-distance signal transmission such as radio frequency and communication.

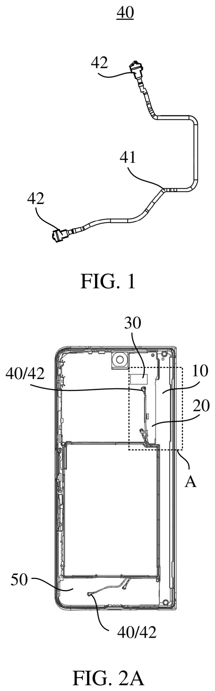

FIG. 1 is a schematic diagram of a structure of a radio frequency cable according to an embodiment of this application.

As shown in FIG. 1, the cable line 40 may include a cable body 41 and cable connectors 42 located at two ends of the cable body 41. The cable connector 42 is configured to be plugged into a circuit board, so that a signal is transmitted to a radio frequency processor close to the circuit board.

The cable line 40 is configured to connect a radio frequency circuit and an antenna in an electronic device, so that the electronic device can perform radio frequency communication by using the connected radio frequency circuit and antenna. The radio frequency circuit may be located in a main circuit board of the electronic device, and the antenna may be located in a middle frame part of the electronic device.

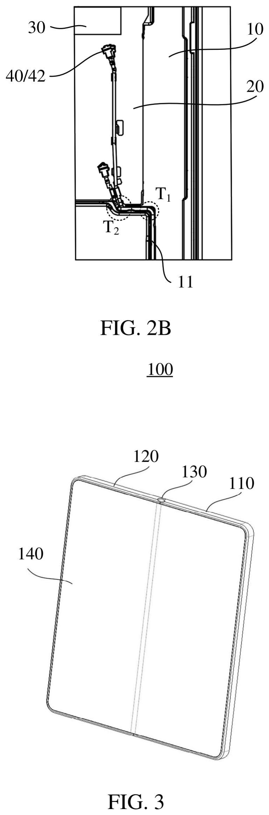

FIG. 2A is a schematic diagram of an internal structure of an electronic device. FIG. 2B is a schematic diagram of a local part in a region A in FIG. 2A.

As shown in FIG. 2A and FIG. 2B, the electronic device includes a middle frame part 10. A main circuit board 20 and a secondary circuit board 50 are arranged on the middle frame part 10. The main circuit board 20 is located in the upper half of the middle frame part 10, and the secondary circuit board 50 is located in the lower half of the middle frame part 10. The main circuit board 20 is configured to be responsible for most system function operations, integrated system control, and the like in the electronic device. The secondary circuit board 50 is configured to be responsible for charging, headset audio signal transmission, signal connection processing, communication processing, sound conversion processing, and the like.

A radio frequency processor 30 is disposed in a region that is of the main circuit board 20 and that is close to the top of the middle frame part 10, and the radio frequency processor 30 is connected to the main circuit board 20. The cable line 40 is connected between the main circuit board 20 and the secondary circuit board 50. The secondary circuit board 50 transmits a collected signal to the main circuit board 20 through the cable line 40, then the main circuit board 20 transmits the signal to the radio frequency processor 30, and the radio frequency processor 30 processes the signal.

The middle frame part 10 may include an antenna (not shown in the figure). The main circuit board 20 may include a radio frequency circuit and a connector connected to the radio frequency circuit. The secondary circuit board 50 may include a connector that is connected to the antenna and that is in a one-to-one correspondence with the antenna.

The radio frequency circuit may include one or more of a power amplifier, a filter, a linear amplifier, and a switch. The radio frequency circuit may be further coupled to the radio frequency processor 30. The radio frequency processor 30 is configured to generate a transmission signal. The radio frequency circuit transmits the transmission signal to the antenna through the cable line 40, and the antenna transmits a generated radio signal outward. The antenna may further receive a radio frequency signal. The antenna transmits the received radio frequency signal to the radio frequency circuit through the cable line 40, and transmits the received radio frequency signal to the radio frequency processor 30 through the radio frequency circuit.

When signal transmission is performed through the cable line 40, the cable line 40 may be connected to the radio frequency circuit and the antenna through the connector on the main circuit board 20 and the connector on the secondary circuit board 50. For example, one cable connector 42 of the cable line 40 is plugged into the main circuit board 20, and is coupled to the connector corresponding to the radio frequency circuit. The other cable connector 42 is plugged into the secondary circuit board 50, and is coupled to the connector corresponding to the antenna. In this way, signal transmission between different circuit boards may be implemented through the cable line 40, so that in a process in which the electronic device performs radio frequency communication, the radio frequency circuit can transmit the radio frequency signal to the antenna through the cable line 40, and the antenna can receive and send the radio frequency signal, thereby implementing radio frequency communication of the electronic device.

For example, the electronic device is a mobile phone. The middle frame part 10 is a large structural member that carries components such as all circuit boards and a battery. Because the middle frame part 10 has a complete structure and a relatively large size, it is convenient for laying of a cabling route of the cable line 40. Therefore, a groove 11 may be disposed on the middle frame part 10, and the cable line 40 is cabled in the groove 11 until the cable line 40 is cabled to the circuit boards (the main circuit board 20 and the secondary circuit board 50), and is connected to the circuit boards. Cabling refers to laying of the cable line 40.

When a signal is transmitted to the radio frequency processor 30 disposed on the main circuit board 20 through the cable line 40, the cable connector 42 is plugged into the main circuit board 20 at a position that is as close as possible to the corresponding radio frequency processor 30, thereby reducing a signal insertion loss. Based on a commonly used cabling manner, the cable line 40 is cabled in the groove 11 of the middle frame part 10, and a direction of the cable line 40 is changed to the left and the cable line 40 is cabled along an edge of the main circuit board 20 when the cable line 40 encounters the main circuit board 20 at a position T₁. The position T₁ is one end that is of the main circuit board 20 and that is away from the radio frequency chip 30. Then, after the cable line 40 is cabled to a position T₂ along the edge of the main circuit board 20, the direction of the cable line 40 needs to be changed once again, so that the cable line 40 is cabled upward. In this case, the cable connector 42 can be plugged into the main circuit board 20 at the position that is close to the radio frequency processor 30. In this way, from the position at which the cable line 40 is cabled to the main circuit board 20 to the radio frequency processor 30, a cabling distance of the cable line 40 is long, and a long route needs to be laid.

However, the cable line is cabled on the main circuit board 20 of the electronic device. In this case, another functional component cannot be welded to the main circuit board 20, resulting in waste of a layout area of the circuit board. In addition, to prevent another component in the electronic device from damaging the cable line 40, hardware components need to be separately welded to the main circuit board 20 to ensure that a cabling route of the cable line 40 is not bent or offset. Consequently, manufacturing complexity is higher, costs are increased, and the layout area of the circuit board is further wasted.

In addition, due to a structural characteristic of the cable line 40, a signal traveling in a conductor has a characteristic of being subjected to electromagnetic radiation and energy leakage, resulting in a difference between a signal input into the cable line 40 and a signal output from the cable line 40, that is, resulting in signal degradation. An outermost layer of the cable line 40 is an insulation layer, and usually, the insulation layer may ensure that there is no signal leakage. However, if the cable line 40 is cabled on the main circuit board 20, the insulation layer cannot implement good electromagnetic shielding. Then, on a premise of a same cabling distance, cabling on the main circuit board 20 causes more leakage, resulting in signal degradation. It can be learned that an arrangement route for the cable line 40 on the main circuit board 20 is long, and the main circuit board 20 causes electromagnetic interference to the cable line 40, resulting in degradation of the signal transmitted through the cable line 40.

To increase a layout area of a circuit board, reduce costs, and avoid signal degradation, an embodiment of this application provides an electronic device 100. A cabling route is laid on another structural member, to shorten a cabling distance of a radio frequency cable on the circuit board.

In the embodiments of this application, the electronic device includes but is not limited to a mobile phone, a foldable mobile phone, a notebook computer, a pad, a laptop computer, a personal digital assistant or a wearable device. Description is provided below with the electronic device being a foldable mobile phone.

To facilitate understanding of the electronic device 100 provided in the embodiments of this application, the following describes a structure of the electronic device 100 in detail with reference to the accompanying drawings.

FIG. 3 is a schematic diagram of a structure of an electronic device 100 according to an embodiment of this application.

As shown in FIG. 3, in some embodiments, the electronic device 100 may include a first body 110, a second body 120, a rotating shaft 130, a screen 140, and a first rear housing and a second rear housing (not shown in the figure). The first body 110 and the second body 120 are respectively disposed on two sides of an axial direction of the rotating shaft 130. The screen 140 covers the first body 110, the second body 120, and the rotating shaft 130, and is separately connected to the first body 110 and the second body 120. The first rear housing is connected to a side that is of the first body 110 and that is away from the screen 140, and the second rear housing is connected to a side that is of the second body 120 and that is away from the screen 140.

The first body 110 and the second body 120 are separately rotatably connected to the rotating shaft 130, so that an angle between the first body 110 and the second body 120 decreases until the electronic device 100 is in a folded state, or an angle between the first body 110 and the second body 120 increases until the electronic device 100 is in an unfolded state.

The screen 140 may be a bendable flexible screen. A state shown in FIG. 3 is a schematic diagram in which the electronic device 100 is in the unfolded state. In this case, the first body 110 and the second body 120 are distributed on two sides of the rotating shaft 130 in parallel, to flatten the flexible screen.

Because rotation directions of the first body 110 and the second body 120 are different, the flexible screen may be hidden in or surround a body of the electronic device 100 in the folded state. When the first body 110 and the second body 120 are folded toward a front surface of the flexible screen, the flexible screen is hidden in the body of the electronic device 100 in the folded state. In this case, the electronic device may be referred to as an electronic device with an inward foldable screen, for example, a mobile phone with an inward foldable screen. When the first body 110 and the second body 120 are folded toward a back surface of the flexible screen, the flexible screen surrounds the body of the electronic device 100 in the folded state. In this case, the electronic device 100 may be referred to as an electronic device with an outward foldable screen, for example, a mobile phone with an outward foldable screen.

For ease of describing an internal structure layout of the electronic device 100, the body (including the first body 110 and the second body 120) of the electronic device 100 is defined to include a first surface 100a and a second surface 100b. The first surface 100a is a surface that is of the body and that faces a rear housing of the body, and the second surface 100b is a surface that is of the body and that faces the screen 140. That is, the first surface 100a and the second surface 100b are opposite surfaces.

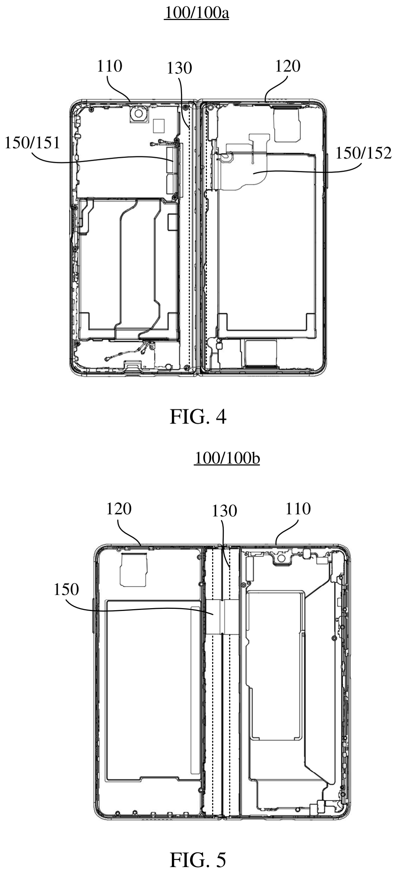

FIG. 4 is a schematic diagram of a first internal structure of the electronic device 100 according to an embodiment of this application.

FIG. 5 is a schematic diagram of a second internal structure of the electronic device 100 according to an embodiment of this application.

A state shown in FIG. 4 is a schematic diagram of a structure of the first surface 100a of the electronic device 100, and a state shown in FIG. 5 is a schematic diagram of a structure of the second surface 100b of the electronic device 100.

As shown in FIG. 4 and FIG. 5, in some embodiments, if the electronic device 100 is a foldable mobile phone, a flexible printed circuit (Flexible Printed Circuit, FPC) 150 connected to a main circuit board is usually arranged between the first body 110 and the second body 120. The flexible printed circuit 150 has excellent characteristics such as being lightweight, thin, and freely bendable or foldable.

The flexible printed circuit 150 is disposed across the rotating shaft 130 in a first direction, and is connected between the first body 110 and the second body 120. The flexible printed circuit 150 may include a first end 151 and a second end 152 that are opposite to each other. The first end 151 is connected to the first body 110 at the first surface 100a of the electronic device 100. The second end 152 passes through the first surface 100a and enters the second surface 100b, then passes through the second surface 100b and enters the first surface 100a, and is finally connected to the second body 120 at the first surface 100a. The first direction is perpendicular to the axial direction of the rotating shaft 130.

The main circuit board of the electronic device 100 may be disposed in the first body 110 or the second body 120. A cabling route of a radio frequency cable is determined based on a layout position of the main circuit board. For example, when the main circuit board is disposed in the first body 110, the cabling route of the radio frequency cable is also laid in the first body 110.

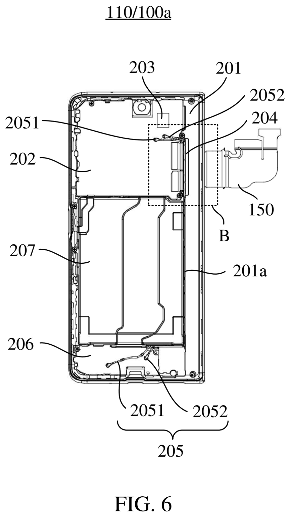

FIG. 6 is a schematic diagram of a first structure of the first body 110 according to an embodiment of this application.

A state shown in FIG. 6 is a schematic diagram of a structure of the first surface 100a of the first body 110.

As shown in FIG. 4 and FIG. 6, in some embodiments, the first body 110 includes a first circuit board 202 and a cable 205. The first circuit board 202 is spaced from the rotating shaft 130. The cable 205 is disposed between the first circuit board 202 and the rotating shaft 130, and at least partially extends in the axial direction of the rotating shaft 130.

The first circuit board 202 may be the main circuit board of the electronic device 100. The cable 205 may be a radio frequency cable or another cable configured in the electronic device for signal transmission. An example in which the cable 205 is a radio frequency cable 205 is used for description below. The radio frequency cable 205 is configured to implement signal transmission between circuit boards in the electronic device 100. A signal may include a radio frequency signal and/or a communication signal. For structural characteristics of the radio frequency cable 205, refer to the structural characteristics of the cable line 40 shown in FIG. 1. Details are not described herein again.

In this way, the electronic device 100 provided in this embodiment of this application provides a cabling manner, so that the cable 205 can be cabled externally instead of being cabled on the first circuit board 202. Such a cabling manner does not occupy a layout area of the first circuit board 202, so that the first circuit board 202 has a larger layout area for arranging another functional component. In addition, a quantity of hardware components arranged on the first circuit board 202 may be reduced, thereby reducing costs. In addition, signal interference of the first circuit board 202 to the cable 205 may be further reduced, thereby ensuring signal quality.

In some embodiments, refer to FIG. 4 and FIG. 6 again. In this embodiment of this application, the radio frequency cable 205 is laid on a side that is of the first body 110 and that is close to the rotating shaft 130 instead of being laid on a side that is away from the rotating shaft 130. The reason is that the side that is of the first body 110 and that is away from the rotating shaft 130 is a button side. In this way, the first body 110 includes a side button position, a slot is opened on the first body 110 corresponding to the side button position to accommodate a side button and a related electronic component. In addition, sealing between the first body 110 and a battery cover is performed by using a back adhesive, so that a narrowest sealed position of the first body 110 is on the button side. If the radio frequency cable 205 is cabled at this position, a corresponding cable slot needs to be added to the first body 110, and a vertical wall of the first body 110 needs to be continuously thickened rightward. However, there is a battery compartment 207 on a right side. In this case, a battery needs to be entirely thinned due to rightward thickening, which is adverse to laying of the battery. Therefore, in this embodiment of this application, the radio frequency cable 205 is laid on the side that is of the first body 110 and that is close to the rotating shaft 130. Therefore, another component in the electronic device 100 is not affected.

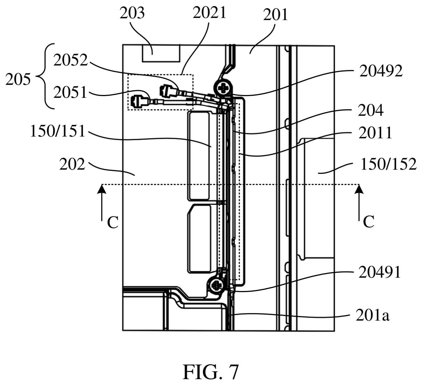

FIG. 7 is a schematic diagram of a structure of a region B in FIG. 6.

As shown in FIG. 4 and FIG. 7, in some embodiments, the first body 110 further includes a radio frequency chip module 203 and a bracket 204.

The radio frequency chip module 203 is disposed on the first circuit board 202 and is electrically connected to the first circuit board 202. Based on a layout characteristic of components in the electronic device 100, the radio frequency chip module 203 may be disposed in a region that is of the first circuit board 202 and that is close to the top of the first body 110.

The radio frequency chip module 203 is configured to receive, through the first circuit board 202, a signal transmitted by the radio frequency cable 205, and process the signal. The radio frequency chip module 203 is further configured to generate a signal, and transmit the signal to an antenna through the radio frequency cable 205, so that the signal is transmitted outward through the antenna.

The bracket 204 is disposed between the first circuit board 202 and the rotating shaft 130. The bracket 204 is configured to guide the cabling route of the radio frequency cable 205. For example, the bracket 204 may be made of stainless steel, plastic, aluminum alloy, or the like.

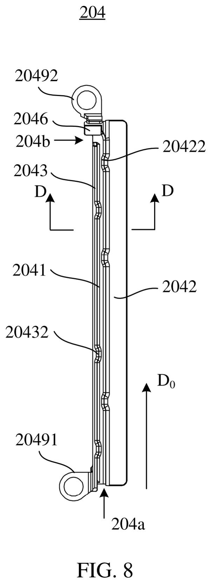

FIG. 8 is a schematic diagram of a first structure of the bracket 204 according to an embodiment of this application.

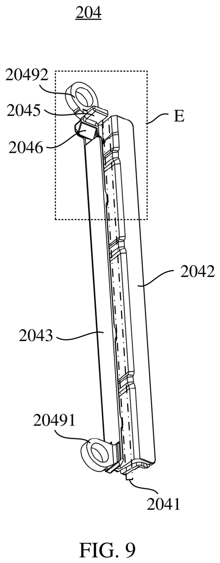

FIG. 9 is a schematic diagram of a second structure of the bracket 204 according to an embodiment of this application.

FIG. 9 is a schematic diagram of the structure shown in FIG. 8 from another perspective.

As shown in FIG. 4, FIG. 7, FIG. 8, and FIG. 9, in some embodiments, the bracket 204 includes a cable slot 2041. A cabling direction D₀ of the cable slot 2041 is parallel to the rotating shaft 130, and the cable slot 2041 is used for cabling of the radio frequency cable 205.

The cable slot 2041 may run through two ends of a length direction of the bracket 204. The cabling direction D₀ of the cable slot 2041 is the length direction of the bracket 204, so that an entrance 204a of the cable slot 2041 in the cabling direction D₀ can be located at one end of the length direction of the bracket 204, and an exit 204b in the cabling direction D₀ can be located at the other end of the length direction of the bracket 204. In this way, cabling in the length direction of the bracket 204 may prolong a cabling distance, thereby better laying the radio frequency cable 205, and reducing cabling of the radio frequency cable 205 on another component.

In some embodiments, the cable slot 2041 may be formed through inward recession of a surface of the bracket 204 by a first depth. In this way, the cable slot 2041 may be a slot with an opening at one end, thereby facilitating cabling.

In some embodiments, the cable slot 2041 may be formed at a center of the length direction of the bracket 204, and the bracket 204 is of a hollowed structure. In this way, the bracket 204 may wrap the radio frequency cable 205 to stably fasten the radio frequency cable 205, thereby preventing the radio frequency cable 205 from being released from the cable slot 2041.

The radio frequency cable 205 is cabled in the cable slot 2041 to restrict a position of the radio frequency cable 205, thereby preventing the cabling route of the radio frequency cable 205 from being bent or offset. A depth of the cable slot 2041 is greater than or equal to a diameter of the radio frequency cable 205.

One end of the radio frequency cable 205 is configured to receive a signal, and the other end of the radio frequency cable 205 passes through the cable slot 2041 and extends to a first region 2021 of the first circuit board 202. The first region 2021 includes a connector (not shown in the figure), the other end of the radio frequency cable 205 is plugged into the connector, to be connected to the first circuit board 202. The first region 2021 is a region that is of the first circuit board 202 and that is close to the radio frequency chip module 203.

The exit 204b of the cable slot 2041 in the cabling direction D₀ is close to the radio frequency chip module 203, and the radio frequency cable 205 is led out from the exit 204b of the cable slot 2041, to encounter the first circuit board 202. In this way, if a position at which the radio frequency cable 205 encounters the first circuit board 202 is close to the radio frequency chip module 203, the cabling direction of the radio frequency cable 205 may be changed, so that the radio frequency cable 205 is cabled to the first circuit board 202, and further extends to the region close to the radio frequency chip module 203. The first circuit board 202 may include a radio frequency circuit. The radio frequency cable 205 may be connected to the radio frequency chip module 203 through the radio frequency circuit of the first circuit board 202, to transmit a signal to the radio frequency chip module 203. In this way, the radio frequency cable 205 may be cabled externally to a position almost closest to the radio frequency chip module 203, and then enters the region that is of the first circuit board 202 and that is close to the radio frequency chip module 203, that is, cabled to an upper region of the first circuit board 202, to ensure a smallest layout area occupied by cabling on the first circuit board 202.

In the electronic device 100 provided in this embodiment of this application, the radio frequency cable 205 is laid by using the bracket 204. The radio frequency cable 205 is cabled in the cable slot 2041 on the bracket 204, to better restrict the cabling route of the radio frequency cable 205, thereby avoiding bending or offset. In this way, the radio frequency cable 205 may be cabled externally to a position almost closest to the radio frequency chip module 203, and then enters the region that is of the first circuit board 202 and that is close to the radio frequency chip module 203, thereby shortening the cabling distance of the radio frequency cable 205 on the first circuit board 202, and ensuring the smallest layout area occupied by cabling on the first circuit board 202. In addition, the radio frequency cable 205 may be connected to the region close to the radio frequency chip module 203, which can reduce electromagnetic interference of the first circuit board 202 to the radio frequency cable 205, avoid signal degradation, and further reduce occupation of the layout area on the first circuit board 202, thereby enabling the first circuit board 202 to have a larger layout area for arranging another functional component. In addition, the radio frequency cable 205 may be fastened by the bracket 204, to reduce the quantity of hardware components arranged on the first circuit board 202, thereby further reducing occupation of the layout area on the first circuit board 202, and reducing costs.

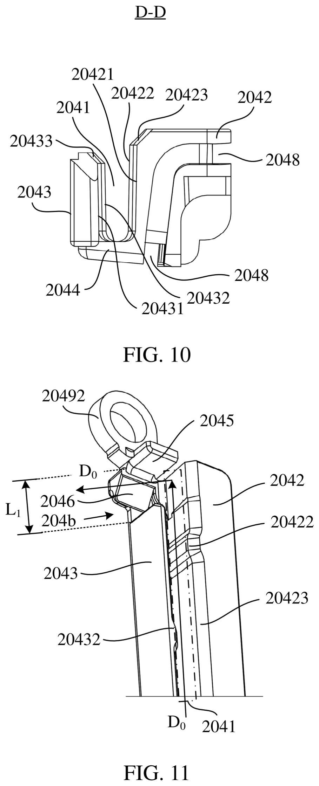

FIG. 10 is a view of a local part that is seen from a cross section D-D in FIG. 8.

FIG. 10 shows only a structure in which the bracket 204 includes a main bracket 2042, a side plate 2043, and a support plate 2044, and another structure of the bracket 204 is not shown.

As shown in FIG. 7, FIG. 8, and FIG. 10, in some embodiments, the bracket 204 may include a main bracket 2042, a side plate 2043, and a support plate 2044. The main bracket 2042 is close to the rotating shaft 130, the side plate 2043 is close to the first circuit board 202, there is a gap between the main bracket 2042 and the side plate 2043, and the main bracket 2042 is connected to the side plate 2043 by using the support plate 2044 to form the cable slot 2041.

In this way, the cable slot 2041 with an opening on one side may be formed, and the radio frequency cable 205 may be laid in the cable slot 2041 through the opening, thereby facilitating laying of the radio frequency cable 205.

In some embodiments, the bracket 204 may further include a first fastening part 20491 and a second fastening part 20492. The first fastening part 20491 and the second fastening part 20492 are located on two ends of the bracket 204 in the cabling direction D₀. The first fastening part 20491 and the second fastening part 20492 may be located on a same side of the cabling direction.

For example, the first fastening part 20491 may be connected to a region that is of the side plate 2043 and that corresponds to the entrance of the cable slot 2041, and the second fastening part 20492 may be connected to a region that is of the support plate 2044 and that corresponds to the exit of the cable slot 2041.

The first fastening part 20491 and the second fastening part 20492 are configured to be connected to the first body 110. For example, both the first fastening part 20491 and the second fastening part 20492 may be of a ring-shape structure.

FIG. 11 is a schematic diagram of a structure of a region E in FIG. 9.

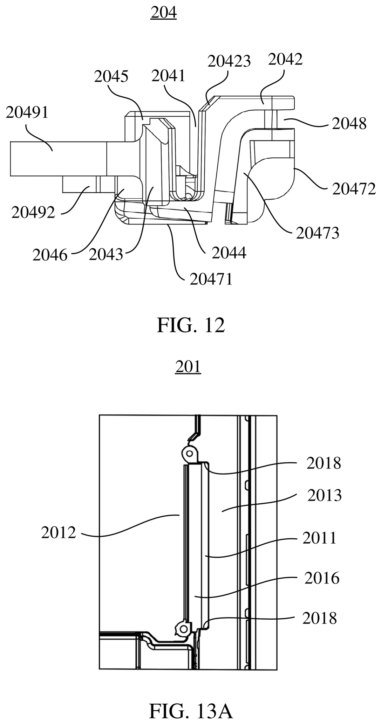

FIG. 12 is a side view of the bracket 204 according to an embodiment of this application.

As shown in FIG. 11 and FIG. 12, in some embodiments, the bracket 204 may further include a baffle plate 2045, and the baffle plate 2045 is configured to limit the position of the radio frequency cable 205.

The baffle plate 2045 is located at one end of the length direction of the bracket 204, and is located at the exit 204b of the cable slot 2041. The baffle plate 2045 may be located at a joint between the second fastening part 20492 and the support plate 2044, the baffle plate 2045 is connected to the support plate 2044, and the baffle plate 2045 is perpendicular to the length direction of the bracket 204. In this way, the baffle plate 2045 may be used to prevent the radio frequency cable 205 from being cabled beyond a region in which the bracket 204 is located, for example, prevent the radio frequency cable 205 from being cabled to the second fastening part 20492. A cabling position of the radio frequency cable 205 is limited by the baffle plate 2045, to avoid interaction between the radio frequency cable 205 and another component in the first body 110.

In some embodiments, a length of the side plate 2043 in the cabling direction D₀ is less than a length of the main bracket 2042 in the cabling direction, so that there is a first distance L₁ between the baffle plate 2045 and the side plate 2043. Therefore, the exit 204b is formed between the baffle plate 2045 and the side plate 2043, and the exit 204b faces the first circuit board 202 and is close to the radio frequency chip module 203.

In this way, the cabling direction D₀ of the radio frequency cable 205 cabled to the exit 204b may be changed by the baffle plate 2045, to change the direction of the radio frequency cable 205 at the exit, so that the radio frequency cable 205 can be continuously cabled toward the first circuit board 202. Therefore, when signal transmission is performed between the radio frequency cable 205 and the radio frequency chip module 203, there is a shortest cabling distance on the first circuit board 202.

In some embodiments, the bracket 204 may further include a guide plate 2046. The guide plate 2046 is located at a joint between the support plate 2044 and the baffle plate 2045, and forms an inclined surface facing the side plate 2043.

The guide plate 2046 is configured to enhance strength of the bracket 204. In this way, the guide plate 2046 may be used to support and guide the radio frequency cable 205. In this way, the guide plate 2046 assists the baffle plate 2045 in changing the cabling direction D₀ of the radio frequency cable 205, so that the radio frequency cable 205 is cabled toward the first circuit board 202.

With reference to FIG. 10 and FIG. 11 again, in some embodiments, the main bracket 2042 may include a first sidewall 20421 facing the side plate 2043, the first sidewall 20421 includes at least one spaced first cable clamp part 20422, and the first cable clamp part 20422 protrudes toward the side plate 2043.

The side plate 2043 may include a second sidewall 20431 facing the first sidewall 20421, the second sidewall 20431 includes at least one spaced second cable clamp part 20432, and the second cable clamp part 20432 protrudes toward the first sidewall 20421.

A quantity of first cable clamp parts 20422 may be the same as or different from a quantity of second cable clamp parts 20432. The first cable clamp part 20422 and the second cable clamp part 20432 may be disposed in a staggered manner or in a one-to-one correspondence. The first cable clamp part 20422 and the second cable clamp part 20432 separately protrude toward each other in the cable slot 2041. When the radio frequency cable 205 is cabled in the cable slot 2041, the radio frequency cable 205 may be fastened by using the first cable clamp parts 20422 and the second cable clamp parts 20432, thereby preventing the radio frequency cable 205 from being released from the cable slot 2041, and preventing the cabling route of the radio frequency cable 205 from being bent or offset. The position of the radio frequency cable 205 is restricted by the first cable clamp parts 20422 and the second cable clamp parts 20432, thereby avoiding interaction between the radio frequency cable 205 and another component in the first body 110.

In some embodiments, the main bracket 2042 may include a first chamfer 20423, and the first chamfer 20423 is located at an edge that is of the first sidewall 20421 and that is away from the support plate 2044. The side plate 2043 includes a second chamfer 20433, and the second chamfer 20433 is located at an edge that is of the second sidewall 20431 and that is away from the support plate 2044.

The first chamfer 20423 and the second chamfer 20433 are located at the opening of the cable slot 2041. In this way, when the radio frequency cable 205 is laid in the cable slot 2041, the first chamfer 20423 and the second chamfer 20433 may facilitate laying of the radio frequency cable 205, and prevent the bracket 204 from scratching the radio frequency cable 205.

Refer to FIG. 6 and FIG. 7 again. In some embodiments, the first body 110 may further include a middle frame 201. The middle frame 201 is a structural member configured to carry another component in the electronic device 100. Antennas (not shown in the figure) are disposed in different regions of the middle frame 201.

FIG. 13A is a schematic diagram of a local part of the middle frame 201 according to an embodiment of this application.

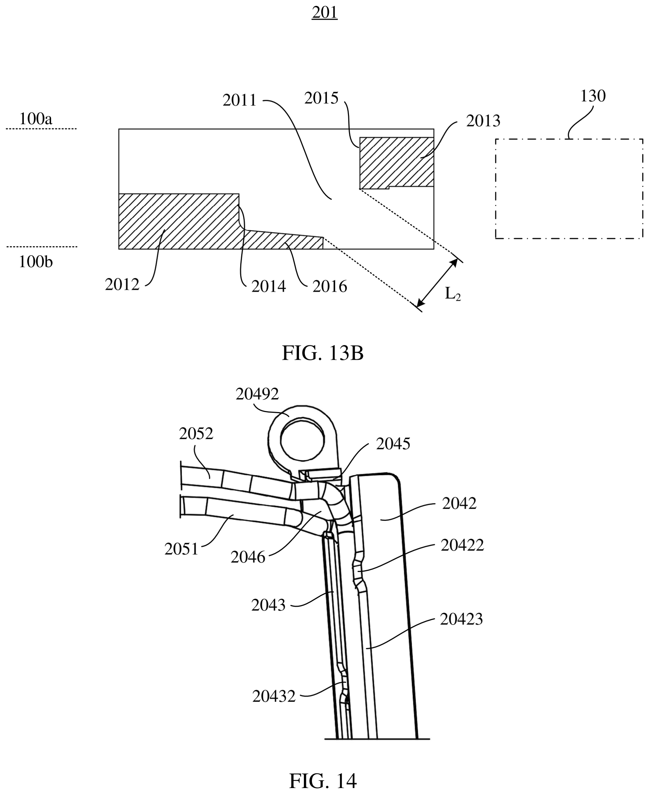

FIG. 13B is a schematic diagram of a first local part that is seen from a cross section C-C in FIG. 7.

FIG. 13B shows only a structure in which the middle frame 201 includes a through hole 2011, and another structure is not shown.

As shown in FIG. 4, FIG. 7, FIG. 13A, and FIG. 13B, in some embodiments, a region that is of the middle frame 201 and that is close to the rotating shaft 130 includes a through hole 2011. The first surface 100a and the second surface 100b are in communication through the through hole 2011.

Similarly, the second body 120 includes a second middle frame (not shown in the figure), and a region that is of the second middle frame and that is close to the rotating shaft 130 includes a second through hole (not shown in the figure). The first surface 100a and the second surface 100b are in communication through the second through hole, and the second through hole may be symmetrical with the through hole 2011 with respect to the rotating shaft 130. In this way, the through hole 2011 and the second through hole may be used for the flexible printed circuit 150 to pass through, so that the flexible printed circuit 150 is separately connected to the first body 110 and the second body 120.

The first circuit board 202 is arranged on the first surface 100a of the middle frame 201, is located at the upper half of the middle frame 201, and is close to the through hole 2011. The first circuit board 202 is located on a side that is of the through hole 2011 and that is away from the rotating shaft 130, and the through hole 2011 is disposed close to the first circuit board 202, so that the flexible printed circuit 150 passes through the through hole 2011, to be connected to the first circuit board 202. In this way, the first circuit board 202 is connected to the first end 151 of the flexible printed circuit 150. The second end 152 of the flexible printed circuit 150 passes through the through hole 2011 and enters the second surface 100b, and then passes through the second through hole and enters the first surface 100a, to be connected to the second body 120.

Based on the layout characteristic of the components in the electronic device 100, the radio frequency chip module 203 may be disposed in a region that is of the first circuit board 202 and that is close to the top of the middle frame 201, so that the radio frequency chip module 203 can be close to the through hole 2011.

When the electronic device 100 changes into the folded state, the rotating shaft 130 is exposed to the outside for the mobile phone with an inward foldable screen. However, the flexible printed circuit 150 is disposed across the rotating shaft 130, and the through hole 2011 that is in the middle frame 201 and through which the flexible printed circuit 150 passes causes external dust, liquid, or the like to enter the body, for example, enter a circuit board region, and the dust, liquid, or the like causes damage to the components such as a circuit board.

Therefore, in some embodiments, the bracket 204 is disposed in the through hole 2011 and is connected to the middle frame 201, and the bracket 204 is used to seal the through hole 2011. In this way, the cable slot 2041 may be formed through inward recession, by a first depth, of a surface that is of the bracket 204 and that is away from the through hole 2011.

In the electronic device provided in this embodiment of this application, the bracket 204 is used to seal the through hole 2011, to prevent the external dust, liquid, or the like from entering the body.

In some embodiments, when the bracket 204 is connected to the middle frame 201, the first fastening part 20491 and the second fastening part 20492 of the bracket 204 may be separately fastened, by using screws, to the middle frame 201 located on an edge of the through hole 2011, to implement fastening of the bracket 204 to the first body 110, thereby ensuring a sealing effect of the bracket 204 on the through hole 2011.

The electronic device 100 provided in this embodiment of this application is applied to a foldable mobile phone scenario. The first body 110 and the second body 120 are respectively disposed on the two sides of the rotating shaft 130. The middle frame 201 of the first body 110 includes the through hole 2011, and the through hole 2011 is close to the rotating shaft 130. The first circuit board 202 is located on the side that is of the through hole 2011 and that is away from the rotating shaft 130, and the radio frequency chip module 203 is disposed on the first circuit board 202. The first end 151 of the flexible printed circuit 150 is connected to the first circuit board 202, and the second end 152 passes through the through hole 2011 and extends to the second body 120, and is connected to the second body 120. The bracket 204 is disposed in the through hole 2011 to seal the through hole 2011, so that the bracket 204 is adjacent to the first circuit board 202. Therefore, when the radio frequency cable 205 is laid, the radio frequency cable 205 is cabled in the cable slot 2041 on the bracket 204, that is, cabled externally to the position almost closest to the radio frequency chip module 203, and then enters the region that is of the first circuit board 202 and that is close to the radio frequency chip module 203, thereby shortening the cabling distance of the radio frequency cable 205 on the first circuit board 202, and ensuring the smallest layout area occupied by cabling on the first circuit board 202. In addition, the radio frequency cable 205 may be connected to the region close to the radio frequency chip module 203, which can reduce electromagnetic interference of the first circuit board 202 to the radio frequency cable 205, avoid signal degradation, and further reduce occupation of the layout area on the first circuit board 202, thereby enabling the first circuit board 202 to have a larger layout area for arranging another functional component. In addition, the radio frequency cable 205 may be fastened by the bracket 204, to reduce the quantity of hardware components arranged on the first circuit board 202, thereby further reducing occupation of the layout area on the first circuit board 202, and reducing costs.

Refer to FIG. 4, FIG. 6, FIG. 7, and FIG. 8 again. In some embodiments, the first body 110 may further include a second circuit board 206 and a battery compartment 207. The second circuit board 206 and the battery compartment 207 are arranged on the first surface 100a of the middle frame 201. The second circuit board 206 may be a secondary circuit board of the electronic device 100, and is configured to be connected to an antenna on the middle frame 201 for signal collection. The battery compartment 207 is configured to mount a battery.

The second circuit board 206 is disposed, in the axial direction of the rotating shaft 130, on a side that is of the first circuit board 202 and that is away from the radio frequency chip module 203, and the second circuit board 206 and the first circuit board 202 are respectively disposed on two sides of the battery compartment 207 in the axial direction of the rotating shaft 130. The battery compartment 207 is located between the first circuit board 202 and the second circuit board 206, so that both the first circuit board 202 and the second circuit board 206 can be connected to the battery in the battery compartment 207. For example, the first circuit board 202 is located in an upper region of the middle frame 201, the battery compartment 207 is located in a middle region of the middle frame 201, and the second circuit board 206 is located in a lower region of the middle frame 201.

The second circuit board 206 includes a connector, and the connector may be connected to an antenna disposed in a region that is of the middle frame 201 and that corresponds to the second circuit board 206. One end that is of the radio frequency cable 205 and that is configured to receive a signal is plugged into the connector of the second circuit board 206, to implement connection between the radio frequency cable 205 and the second circuit board 206. In this way, the end that is of the radio frequency cable 205 and that is configured to receive a signal is connected to the second circuit board 206, to receive a signal collected by the antenna. The other end of the radio frequency cable 205 passes through the cable slot 2041 and is connected to the first region 2021 of the first circuit board 202 to transmit the signal to the radio frequency chip module 203 connected to the first region 2021.

In some embodiments, there may be a plurality of radio frequency cables 205 for transmitting different signals. For example, the radio frequency cables 205 may include a first radio frequency cable 2051 and a second radio frequency cable 2052. The first radio frequency cable 2051 is configured to transmit one of a radio frequency signal and a communication signal, and the second radio frequency cable 2052 is configured to transmit the other of the radio frequency signal and the communication signal.

When the electronic device 100 uses a signal transmission manner of bottom signal collection + top signal processing, one end that is of each of the first radio frequency cable 2051 and the second radio frequency cable 2052 and that is configured to receive a signal is connected to the second circuit board 206.

Because there is a distance between the second circuit board 206 and the bracket 204, for ease of cabling, with reference to FIG. 6 and FIG. 7 again, a second cable slot 201a may be disposed in a region that is of the middle frame 201 and that is close to the second circuit board 206, and the second cable slot 201a is in communication with the cable slot 2041. In this case, the other end of each of the first radio frequency cable 2051 and the second radio frequency cable 2052 first passes through the second cable slot 201a, and then enters the cable slot 2041, and finally is cabled to the first circuit board 202 and is connected to the first region 2021.

In the electronic device 100 provided in this embodiment of this application, other ends of the radio frequency cables 205 (the first radio frequency cable 2051 and the second radio frequency cable 2052) may be directly cabled to the cable slot 2041 on the bracket 204 from the second cable slot 201a on the middle frame 201, may extend to the first region 2021 of the first circuit board 202 through only one time of direction changing when extending to the first circuit board 202 from the cable slot 2041, and are connected to the radio frequency chip module 203. With reference to the existing cabling manner shown in FIG. 2B, the cable line 40 is cabled in the groove 11 of the middle frame part 10, first needs to be cabled to the main circuit board 20 through one time of direction changing (at the position T₁), and extends to the region of the radio frequency processor 30 through another time of direction changing on the main circuit board 20 (at the position T₂). It can be learned that in the existing cabling manner, direction changing needs to be performed twice to enable the cable line 40 to perform signal transmission with the radio frequency processor 30. In this embodiment of this application, direction changing needs to be performed only once to enable the radio frequency cable 205 to perform signal transmission with the radio frequency chip module 203. One time of direction changing for the radio frequency cable 205 may reduce stress, thereby improving performance of the radio frequency cable 205. In addition, large parts of cabling distances of the first radio frequency cable 2051 and the second radio frequency cable 2052 are cabled externally, thereby shortening cabling distances of the first radio frequency cable 2051 and the second radio frequency cable 2052 on the circuit boards, and avoiding excessive occupation of layout spaces of the circuit boards.

FIG. 14 is a schematic diagram of an assembly structure of the bracket 204 and the radio frequency cable 205 according to an embodiment of this application.

As shown in FIG. 14, in some embodiments, when the electronic device 100 implements signal transmission through two radio frequency cables 205, the first radio frequency cable 2051 and the second radio frequency cable 2052 are laid in the cable slot 2041 of the bracket 204. The first radio frequency cable 2051 and the second radio frequency cable 2052 may be laid in the cable slot 2041 in a stacking form. For example, the first radio frequency cable 2051 is located at the bottom of the cable slot 2041, the second radio frequency cable 2052 is located above the first radio frequency cable 2051, and the depth of the cable slot 2041 is greater than or equal to a total height of the first radio frequency cable 2051 and the second radio frequency cable 2052.

When the first radio frequency cable 2051 and the second radio frequency cable 2052 are cabled to the baffle plate 2045, a cabling direction of the second radio frequency cable 2052 may be changed by the baffle plate 2045, and a cabling direction of the first radio frequency cable 2051 may be changed by the guide plate 2046. In addition, both the baffle plate 2045 and the guide plate 2046 may prevent the first radio frequency cable 2051 and the second radio frequency cable 2052 from being cabled beyond the region in which the bracket 204 is located, so that the first radio frequency cable 2051 and the second radio frequency cable 2052 can be cabled according to a designed cabling route.

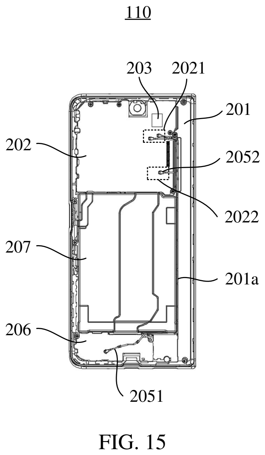

FIG. 15 is a schematic diagram of a second structure of the first body 110 according to an embodiment of this application.

As shown in FIG. 15, in some embodiments, an antenna may also be disposed in a region that is of the middle frame 201 and that corresponds to the first circuit board 202. Therefore, the first circuit board 202 may collect a signal, and transmit, through the radio frequency cable 205, the signal to the radio frequency chip module 203 connected to the first circuit board 202, to implement intra-board signal transmission. In this way, one end of the radio frequency cable 205 is connected to a second region 2022 of the first circuit board 202, and the other end of the radio frequency cable 205 passes through the cable slot 2041 and is connected to a first region 2021 of the first circuit board 202.

When intra-board signal transmission is performed, the first circuit board 202 includes the second region 2022, the second region 2022 includes a connector, and the connector may be connected to the antenna disposed in the region that is of the middle frame 201 and that corresponds to the first circuit board 202. The second region 2022 is a region that is of the first circuit board 202 and that is away from the radio frequency chip module 203.

In this way, the first circuit board 202 includes two connectors. For example, the end that is of the second radio frequency cable 2052 and that is configured to receive a signal is plugged into the connector in the second region 2022, to be connected to the first circuit board 202 in the second region 2022. The other end of the second radio frequency cable 2052 passes through the cable slot 2041 and is plugged into the connector in the first region 2021, to be connected to the first circuit board 202 in the first region 2021.

The end that is of the first radio frequency cable 2051 and that is configured to receive a signal is plugged into the connector of the second circuit board 206, to be connected to the second circuit board 206. The other end of the first radio frequency cable 2051 sequentially passes through the second cable slot 201a and the cable slot 2041 and is plugged into the connector in the first region 2021, to be connected to the first circuit board 202 in the first region 2021.

It should be noted that, in this embodiment of this application, one of the two radio frequency cables may be used to perform intra-board signal transmission and the other one is used to perform signal transmission of bottom signal collection + top signal processing, both the two radio frequency cables may be used to perform intra-board signal transmission, or both the two radio frequency cables may be used to perform signal transmission of bottom signal collection + top signal processing. This is not limited herein.

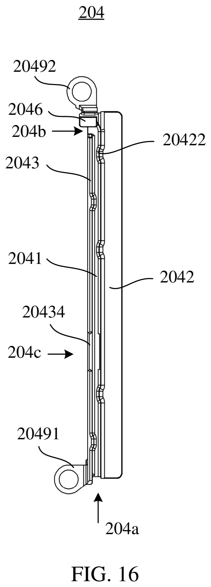

FIG. 16 is a schematic diagram of a third structure of the bracket 204 according to an embodiment of this application.

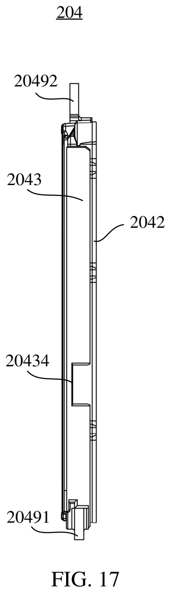

FIG. 17 is a schematic diagram of a fourth structure of the bracket 204 according to an embodiment of this application.

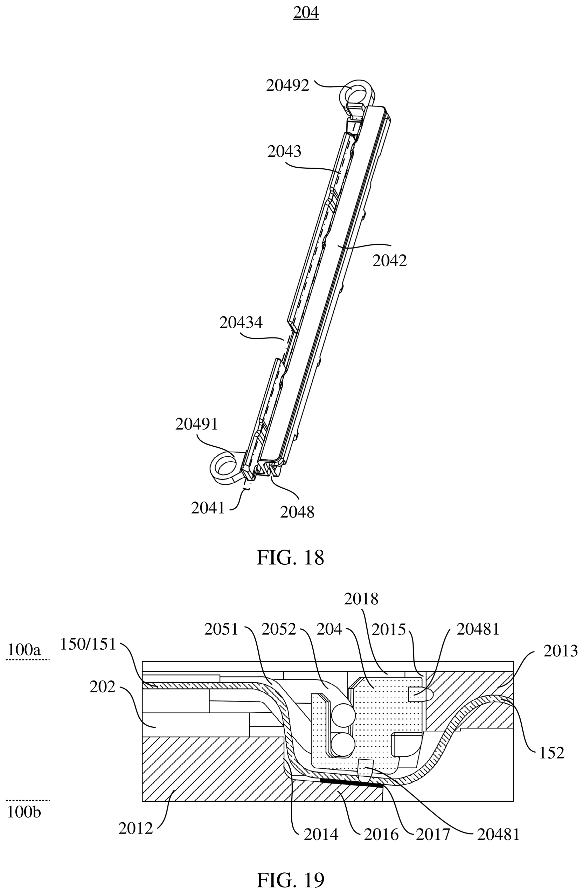

FIG. 18 is a schematic diagram of a fifth structure of the bracket 204 according to an embodiment of this application.

As shown in FIG. 15, FIG. 16, FIG. 17, and FIG. 18, in some embodiments, the side plate 2043 of the bracket 204 includes an opening 20434. The opening 20434 is in communication with the cable slot 2041, and the opening 20434 faces the second region 2022 of the first circuit board 202. In this way, the cable slot 2041 includes two entrances (204a and 204c). The entrance 204c facing the second region 2022 is used for cabling of the second radio frequency cable 2052, and the entrance 204a facing the second circuit board 206 is used for cabling the first radio frequency cable 2051.

One end of the second radio frequency cable 2052 is connected to the second region 2022 of the first circuit board 202, and is configured to receive a signal collected by an antenna corresponding to the second region 2022. The other end of the second radio frequency cable 2052 passes through the opening 20434 from the entrance 204c and is cabled to the cable slot 2041, is cabled to the first circuit board 202 through the cable slot 2041, and is connected to the first circuit board 202 in the first region 2021, to implement intra-board signal transmission. In this way, the second radio frequency cable 2052 may be connected to the radio frequency chip module 203, and the second radio frequency cable 2052 transmits the signal to the radio frequency chip module 203 for processing. For a cabling route of the first radio frequency cable 2051, refer to the content in the foregoing embodiment. Details are not described herein again.

Refer to FIG. 13B again. In some embodiments, when the through hole 2011 is sealed by the bracket 204, the middle frame 201 may include a first part 2012 located on a side that is of the through hole 2011 and that is away from the rotating shaft 130 and a second part 2013 located on a side that is of the through hole 2011 and that is close to the rotating shaft 130. The first part 2012 includes a first side surface 2014 facing the through hole 2011, and the second part 2013 includes a second side surface 2015 facing the through hole 2011. Both the first side surface 2014 and the second side surface 2015 are perpendicular to the first surface 100a, the first side surface 2014 and the second side surface 2015 face each other, and there is a height difference between the first side surface 2014 and the second side surface 2015.

A sealing part 2016 is disposed on the first side surface 2014, and the sealing part 2016 extends toward the second side surface 2015 along the first side surface 2014. The bracket 204 is embedded into the through hole 2011 from the first surface 100a of the middle frame 201. To facilitate a sealing effect of the bracket 204 and the middle frame 201, the sealing part 2016 may be located on a side that is of the first side surface 2014 and that is close to the second surface 100b.

The sealing part 2016 is spaced from the second side surface 2015 by L₂ to form a first channel through which the flexible printed circuit 150 passes.

FIG. 19 is a schematic diagram of a second local part that is seen from a cross section C-C in FIG. 7.

As shown in FIG. 19, in some embodiments, the first end 151 of the flexible printed circuit 150 is connected to the first circuit board 202, and the second end 152 of the flexible printed circuit 150 extends along the sealing part 2016 and passes through the first channel to reach the second body 120.

The sealing part 2016 is adhered to the flexible printed circuit 150 by using an adhesive layer 2017. The adhesive layer 2017 is configured to fasten the flexible printed circuit 150 to the sealing part 2016. In this way, the flexible printed circuit 150 may further seal the through hole 2011.

With reference to content shown in FIG. 8, FIG. 12, FIG. 13B, and FIG. 19, in some embodiments, the bracket 204 may include a first contact surface 20471 facing the sealing part 2016, a second contact surface 20472 facing the second side surface 2015, and third contact surfaces 20473 located on two ends of the first contact surface 20471 in the cabling direction D₀.

For example, the first contact surface 20471 may be formed by surfaces that are of the main bracket 2042 and the support plate 2044 and that face the sealing part 2016; the second contact surface 20472 may be formed by a surface that is of the main bracket 2042 and that is away from the through hole 2011, where the surface is perpendicular to the cabling direction D₀; and the third contact surfaces 20473 may be formed by two end surfaces of the main bracket 2042 in the cabling direction D₀.

The first contact surface 20471 may be perpendicular to the third contact surface 20473, the first contact surface 20471 may be perpendicular to the second contact surface 20472, the second contact surface 20472 may be perpendicular to the third contact surfaces 20473, and the two third contact surfaces 20473 are parallel to each other. The first contact surface 20471, the second contact surface 20472, and the two third contact surfaces 20473 in the bracket 204 are configured to mate with the middle frame 201 to seal the through hole 2011.

Correspondingly, the middle frame 201 may include two third side surfaces 2018 configured to connect the first side surface 2014 to the second side surface 2015 in the cabling direction D₀ (with reference to FIG. 13A). The first third side surface 2018 is configured to connect one end of the first side surface 2014 to one end of the second side surface 2015, the second third side surface 2018 is configured to connect the other end of the first side surface 2014 to the other end of the second side surface 2015, and the first third side surface 2018 is opposite to the second third side surface 2018. In this way, the four side surfaces are successively connected to form the through hole 2011.

The first contact surface 20471 abuts against a region that is of the flexible printed circuit 150 and that is configured to be adhered to the sealing part 2016, the second contact surface 20472 abuts against the second side surface 2015, and the two third contact surfaces 20473 abut against the two third side surfaces 2018 in a one-to-one correspondence, to seal the through hole 2011.

In some embodiments, to improve the sealing effect, the bracket 204 may include an accommodating port 2048. The accommodating port 2048 is continuously formed on the first contact surface 20471, the second contact surface 20472, and the third contact surfaces 20473, so that the accommodating port 2048 can be of a ring-shaped structure.

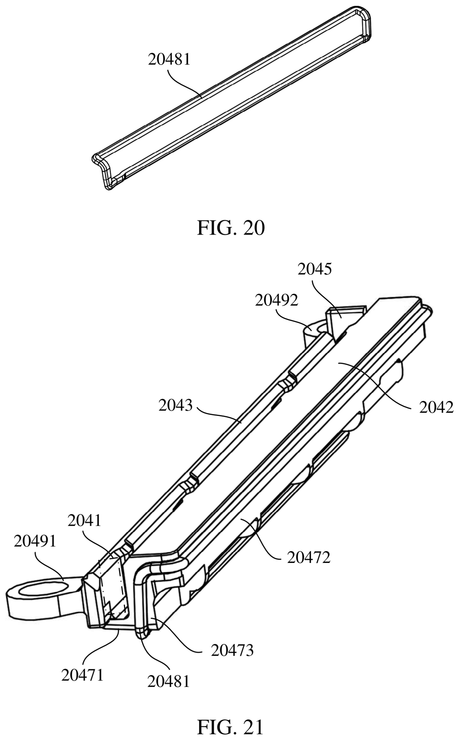

FIG. 20 is a schematic diagram of a structure of a sealing rib 20481 according to an embodiment of this application.

As shown in FIG. 20, in some embodiments, the sealing rib 20481 is filled in the accommodating port 2048. The sealing rib 20481 may be of a ring-shaped structure, and the sealing rib 20481 may use a material that has features of elasticity, deformability, and the like, for example, may be rubber.

FIG. 21 is a schematic diagram of an assembly structure of the bracket 204 and the sealing rib 20481 according to an embodiment of this application.

As shown in FIG. 19 and FIG. 21, in some embodiments, the sealing rib 20481 is embedded into the accommodating port 2048. Because the sealing rib 20481 has the feature of deformability, the sealing rib 20481 may be deformed based on the structure of the accommodating port 2048, to be closely combined with the accommodating port 2048, thereby ensuring the sealing effect.

The sealing rib 20481 protrudes from corresponding contact surfaces relative to the accommodating port 2048, see a dotted line part at the sealing rib 20481 in FIG. 19. In this way, when the bracket 204 is mounted in the through hole 2011, the sealing rib 20481 abuts against the flexible printed circuit 150, and the sealing rib 20481 is pressed by the flexible printed circuit 150 and the sealing part 2016 by using elasticity of the sealing rib 20481, and elastic deformation is generated to exert pressure on the flexible printed circuit 150. Similarly, the sealing rib 20481 abuts against the second side surface 2015 and the third side surfaces 2018 of the middle frame 201, and the sealing rib 20481 is pressed by the side surfaces of the middle frame 201 to generate elastic deformation to exert pressure on the second side surface 2015 and the third side surfaces 2018, thereby improving the sealing effect on the through hole 2011.

In the electronic device 100 provided in this embodiment of this application, the bracket 204 may be used to seal the through hole 2011 through which the flexible printed circuit 150 passes, and may be used for cabling of the radio frequency cable 205. There is no need to add a specific component for cabling of the radio frequency cable 205 in the electronic device 100, and a plurality of functions are integrated into one component, thereby reducing occupation of an internal space of the electronic device 100.

In some embodiments, there may be a plurality of radio frequency cables 205, for example, three or four. When the radio frequency cables 205 are cabled in the cable slot 2041, the depth of the cable slot 2041 is greater than or equal to a total height of the stacked radio frequency cables 205, to restrict positions of the radio frequency cables 205, thereby preventing the cabling route of the radio frequency cables 205 from being bent or offset.

In some embodiments, the radio frequency cable 205 may alternatively be laid in a region that is of the middle frame 201 and in which no button is disposed. For example, if the main circuit board and the secondary circuit board are disposed on the second body 120, because there is no need to dispose a button on a middle frame of the second body 120, a cable slot may be disposed on the middle frame of the second body 120 for cabling of the radio frequency cable 205.

It should be noted that a person skilled in the art can easily figure out another implementation solution of this application after considering this specification and practicing this application that is disclosed herein. This application is intended to cover any variations, functions, or adaptive changes of this application. These variations, functions, or adaptive changes comply with general principles of this application, and include common knowledge or a commonly used technical means in the art that is not disclosed in this application. This specification and the embodiments are merely considered as examples, and the actual scope of this application is pointed out by the following claims.

It should be understood that this application is not limited to the precise structures described above and shown in the accompanying drawings, and various modifications and changes may be made without departing from the scope thereof. The scope of this application is limited only by the appended claims.

## Claims

1. An electronic device, comprising:
a rotating shaft (130); and
a first body (110) and a second body (120) that are respectively disposed on two sides of the rotating shaft (130), wherein
the first body (110) comprises:
a first circuit board (202), wherein the first circuit board (202) is spaced from the rotating shaft (130); and
a cable (205), disposed between the first circuit board (202) and the rotating shaft (130), and at least partially extending in an axial direction of the rotating shaft (130).

2. The electronic device according to claim 1, wherein the first body (110) further comprises:
a bracket (204), disposed between the first circuit board (202) and the rotating shaft (130); and
the bracket (204) comprises a cable slot (2041), a cabling direction of the cable slot (2041) is parallel to the rotating shaft (130), and the cable slot (2041) is used for cabling of the cable (205).

3. The electronic device according to claim 2, wherein
the bracket (204) comprises a main bracket (2042), a side plate (2043), and a support plate (2044), the main bracket (2042) is close to the rotating shaft (130), the side plate (2043) is close to the first circuit board (202), and there is a gap between the main bracket (2042) and the side plate (2043); and
the main bracket (2042) is connected to the side plate (2043) by using the support plate (2044) to form the cable slot (2041).

4. The electronic device according to claim 3, wherein
the bracket (204) further comprises a baffle plate (2045);
the baffle plate (2045) is located at an exit end of the cable slot (2041) and is connected to the support plate (2044), and the baffle plate (2045) is perpendicular to the cabling direction; and
the baffle plate (2045) is configured to limit a position of the cable (205).

5. The electronic device according to claim 4, wherein
there is a first distance L₁ between the baffle plate (2045) and the side plate (2043), so that an exit is formed between the baffle plate (2045) and the side plate (2043), and the exit faces the first circuit board (202).

6. The electronic device according to claim 5, wherein
the bracket (204) further comprises a guide plate (2046);
the guide plate (2046) is located at a joint between the support plate (2044) and the baffle plate (2045), and forms an inclined surface facing the side plate (2043); and
the guide plate (2046) is configured to guide the cable (205).

7. The electronic device according to claim 3, wherein
the main bracket (2042) comprises a first sidewall (20421) facing the side plate (2043), the first sidewall (20421) comprises at least one spaced first cable clamp part (20422), and the first cable clamp part (20422) protrudes toward the side plate (2043);
the side plate (2043) comprises a second sidewall (20431) facing the first sidewall (20421), the second sidewall (20431) comprises at least one spaced second cable clamp part (20432), and the second cable clamp part (20432) protrudes toward the first sidewall (20421); and
the first cable clamp part (20422) and the second cable clamp part (20432) are configured to fasten the cable (205).

8. The electronic device according to claim 7, wherein
the main bracket (2042) comprises a first chamfer (20423), and the first chamfer (20423) is located at an edge that is of the first sidewall (20421) and that is away from the support plate (2044); and
the side plate (2043) comprises a second chamfer (20433), and the second chamfer (20433) is located at an edge that is of the second sidewall (20431) and that is away from the support plate (2044).

9. The electronic device according to claim 2, further comprising a flexible printed circuit (150);
the first body (110) further comprises a middle frame (201), a region that is of the middle frame (201) and that is close to the rotating shaft (130) comprises a through hole (2011), and the first circuit board (202) is disposed on the middle frame (201) and is close to the through hole (2011);
a first end (151) of the flexible printed circuit (150) is connected to the first circuit board (202), and a second end (152) of the flexible printed circuit (150) passes through the through hole (2011) and is connected to the second body (120); and
the bracket (204) is disposed in the through hole (2011) and is connected to the middle frame (201), and the bracket (204) is configured to seal the through hole (2011).

10. The electronic device according to claim 9, wherein
the middle frame (201) comprises a first part (2012) located on a side that is of the through hole (2011) and that is away from the rotating shaft (130) and a second part (2013) located on a side that is of the through hole (2011) and that is close to the rotating shaft (130), the first part (2012) comprises a first side surface (2014) facing the through hole (2011), and the second part (2013) comprises a second side surface (2015) facing the through hole (2011);
a sealing part (2016) is disposed on the first side surface (2014), and the sealing part (2016) extends toward the second side surface (2015) along the first side surface (2014);
the sealing part (2016) is spaced from the second side surface (2015) to form a first channel through which the flexible printed circuit (150) passes; and
the second end (152) of the flexible printed circuit (150) extends along the sealing part (2016) and passes through the first channel to reach the second body (120).

11. The electronic device according to claim 10, wherein
the sealing part (2016) is adhered to the flexible printed circuit (150) by using an adhesive layer (2017).

12. The electronic device according to claim 11, wherein
the bracket (204) comprises a first contact surface (20471) facing the sealing part (2016), a second contact surface (20472) facing the second side surface (2015), and third contact surfaces (20473) located on two ends of the first contact surface (20471) in the cabling direction;
the middle frame (201) comprises two third side surfaces (2018) configured to connect the first side surface (2014) to the second side surface (2015) in the cabling direction; and
the first contact surface (20471) abuts against a region that is of the flexible printed circuit (150) and that is configured to be adhered to the sealing part (2016), the second contact surface (20472) abuts against the second side surface (2015), and the third contact surfaces (20473) abut against the third side surfaces (2018), to seal the through hole (2011).

13. The electronic device according to claim 12, wherein
the bracket (204) comprises an accommodating port (2048), and the accommodating port (2048) is continuously formed on the first contact surface (20471), the second contact surface (20472), and the third contact surfaces (20473); and
a sealing rib (20481) is filled in the accommodating port (2048), and the sealing rib (20481) separately abuts against the flexible printed circuit (150) and the second side surface (2015) and the third side surface (2018) of the middle frame (201), to seal the through hole (2011).

14. The electronic device according to claim 9, wherein
the bracket (204) comprises a first fastening part (20491) and a second fastening part (20492);
the first fastening part (20491) and the second fastening part (20492) are located on two ends of the bracket (204) in the cabling direction; and
the first fastening part (20491) and the second fastening part (20492) are configured to be connected to the middle frame (201).

15. The electronic device according to claim 3, wherein
the first body (110) further comprises a second circuit board (206) and a radio frequency chip module (203);
the radio frequency chip module (203) is disposed on the first circuit board (202) and is connected to the first circuit board (202); and
the second circuit board (206) is disposed, in the axial direction of the rotating shaft (130), on a side that is of the first circuit board (202) and that is away from the radio frequency chip module (203).

16. The electronic device according to claim 15, wherein
the cable (205) is a radio frequency cable;
one end of the radio frequency cable is connected to the second circuit board (206), and the other end of the radio frequency cable passes through the cable slot (2041) and extends to a first region (2021) of the first circuit board (202), to be connected to the first circuit board (202); and
the first region (2021) is a region that is of the first circuit board (202) and that is close to the radio frequency chip module (203).

17. The electronic device according to claim 15, wherein
the cable (205) is a radio frequency cable;
one end of the radio frequency cable is connected to a second region (2022) of the first circuit board (202), and the other end of the radio frequency cable passes through the cable slot (2041) and is connected to a first region (2021) of the first circuit board (202); and
the first region (2021) is a region that is of the first circuit board (202) and that is close to the radio frequency chip module (203), and the second region (2022) is a region that is of the first circuit board (202) and that is away from the radio frequency chip module (203).

18. The electronic device according to claim 17, wherein
the side plate (2043) comprises an opening (20434);
the opening (20434) is in communication with the cable slot (2041), and the opening (20434) faces the second region (2022) of the first circuit board (202); and
the other end of the radio frequency cable passes through the opening (20434) and the cable slot (2041) and is connected to the first region (2021) of the first circuit board (202).
